# EUROPÄISCHE PATENTSCHRIFT

(11) **EP 0 812 010 B1**
(45) Veröffentlichungstag und Bekanntmachung des Hinweises auf die Patenterteilung: **11.09.2002**
(21) Anmeldenummer: 97108932.1
(22) Anmeldetag: 03.06.1997
(51) Int. Cl.: H01L 21/28, H01L 21/765, H01L 29/423

(54) **Verfahren zur Herstellung einer Halbleiterstruktur für einen MOS-Transistor**
Method of manufacturing a semiconductor structure for a MOS transistor
Méthode de fabrication dune structure semiconductrice pour transistor MOS

(30) Priorität: 03.06.1996 DE 19622276
(43) Veröffentlichungstag der Anmeldung: 10.12.1997
(73) Patentinhaber: Infineon Technologies AG, 81669 München (DE)
(72) Erfinder: Kerber, Martin, Dr., 81827 München (DE); Schwalke, Udo, Dr., 84431 Heldenstein (DE)
(74) Vertreter: Zimmermann & Partner

(56) Entgegenhaltungen:
- EP-A- 0 363 689
- EP-A- 0 607 583
- EP-A- 0 755 072
- US-A- 4 696 092
- US-A- 4 984 042
- US-A- 5 376 578

## Beschreibung

Die Erfindung betrifft ein Verfahren zur Herstellung einer Halbleiterstruktur für einen MOS-Transistor.

Die Herstellung von integrierten MOS-Schaltkreisen und insbesondere CMOS-Schaltkreisen erfolgt nach verschiedenen Verfahren, bei denen vielfach die Wannendotierstoffe eingebracht und durch Temperaturbehandlung eingetrieben werden. Dann werden Isolationsbereiche durch lokale Oxidation von Silizium (LOCOS) oder Shallow Trench Isolation (STI) hergestellt. Nach Herstellung der Isolationsbereiche wird auf den aktiven Bereichen durch thermische Oxidation ein Gateoxid gewachsen und mit einer Gateelektrode, die vorzugsweise aus Polysilizium besteht, abgedeckt. Das Polysilizium wird durch eine Lackmaske und Reactive Ion Etching (RIE) strukturiert, wobei die Ätzung ausreichend selektiv zum darunterliegenden Gateoxid sein muß, so daß bei der Ätzung das Substrat nicht angegriffen wird. Die Herstellung der integrierten Schaltung wird in bekannter Weise fortgesetzt.

Bei der Herstellung von solchen integrierten MOS-Transistoren und insbesondere von CMOS-Transistoren treten unter anderem zwei wesentliche Probleme auf. Das eine Problem betrifft die Gateoxidqualität und das andere die Topologie bei der Strukturierung der Gateelektrode. Die Gateoxidqualität ist im wesentlichen durch die Defektdichte und die Durchbruchfeldstärke charakterisiert. Mit zunehmender Anzahl der Prozeßschritte bis zur Herstellung des Gateoxids wird die Gateoxidqualität schlechter, da jeder vorangegangene Prozeßschritt die Defektdichte erhöht und die Oberfläche zunehmend uneben wird. Wünschenswert ist daher, das Gateoxid möglichst frühzeitig, also mit einem der ersten Prozeßschritte herzustellen, und mit einer Gateelektrode abzudecken.

Wird die Isolation von integrierten CMOS-Schaltkreisen beispielsweise durch lokale Oxidation (LOCOS) hergestellt, so befindet sich am Übergang vom aktiven Gebiet zum Isolationsbereich immer eine Topologiestufe, die in der Größenordnung der Dicke der Gateelektrode und damit im Bereich von etwa 0,5 µm liegt. Dies wirkt sich durch unterschiedliche Lackdicken und Reflexionen am Feldoxidrand nachteilig auf die Maßhaltigkeit bei der Strukturierung der Gateelektrode aus. Außerdem bildet sich an der Feldoxidstufe ein Spacer, so daß an dieser Stelle die Gateelektrode deutlich dicker ist als in den übrigen Bereichen. Die größere Dicke an dieser Stelle muß durch eine längere Ätzzeit berücksichtigt werden. Die Ätzung darf jedoch andererseits nicht durch das extrem dünne Gateoxid bis ins Substrat fortschreiten. Daraus resultiert bei gegebener Topologiestufenhöhe an der Feldoxidkante eine sehr hohe Ätzselektivität und/oder ein entsprechend dickes Gateoxid.

Die Isolation von MOS-Transistoren unter Verwendung von Feldplatten ist aus der EP 0 607 583 A2 bekannt. Bei dieser werden zunächst die Feldplatten und nachfolgend das Gate aus mindestens zwei unterschiedlichen Polysiliziumschichten gebildet. Mindestens zwei Polysiliziumschichten aufzubringen, ist auch bei der Halbleiterstruktur aus der US 5,376,578 gegeben.

Der Erfindung liegt daher die **Aufgabe** zugrunde, ein Verfahren zur Herstellung einer Halbleiterstruktur für einen MOS-Transistor, insbesondere einen CMOS-Transistor, zu schaffen, welche eine Herstellung bei weitgehend ausgeglichener Topologie ermöglicht.

Erfindungsgemäß, wird die Aufgabe durch ein Verfahren gelöst, bei dem - in dieser Reihenfolge - auf einem Substrat ein Gateoxid und darüber eine Polysiliziumschicht erzeugt wird, auf die Polysiliziumschicht ein Dielektrikum abgeschieden wird, das Dielektrikum zur Definition aktiver Bereiche strukturiert wird, an bei der Strukturierung entstandenen Rändern ein Spacer hergestellt wird, die Polysiliziumschicht zwischen den Spacern teilweise aufoxidiert wird, die Spacer entfernt werden, das unter den Spacern liegende Polysilizium der Polysiliziumschicht anisotrop entfernt wird, ein Oxid konform abgeschieden wird, an dem abgeschiedenen Oxid eine Spacerätzung durchgeführt wird, die im aktiven Bereich auch das vorher erzeugte Oxid entfernt, und im aktiven Bereich Silizium bis zur Höhe der angrenzenden Oxidstruktur abgeschieden wird.

Durch dieses Verfahren wird eine Halbleiterstruktur für einen MOS-Transistor und insbesondere einen CMOS-Transistor mit einer Feldplattenisolation geschaffen. Dabei wird ein erstes Oxid als Gateoxid und die darauf abgeschiedene erste Polysiliziumschicht gleichzeitig als ein Teil der Gateelektrode und außerhalb der aktiven Bereiche als Feldplattenschicht verwendet. Die Herstellung von Gateoxid und erster Polysiliziumschicht erfolgt am Anfang der Prozeßfolge, wodurch eine optimale Gateoxidqualität erreicht wird. Die Trennung der Gatebereiche von den Isolationsbereichen erfolgt selbstjustiert durch Mikrotrenchätzung. Diese Trenches oder Gräben werden durch einen Spacer aufgefüllt. Auf die freiliegenden ersten Polysiliziumbereiche wird selektiv eine weitere Polysiliziumschicht abgeschieden, deren Dicke so gewählt ist, daß die Dicke der resultierenden Gateelektrode etwa gleich der Dicke der ersten Polysiliziumschicht und der Feldoxidschicht ist. Dadurch entsteht eine Oberfläche mit minimaler Topologie, die eine optimale Voraussetzung für die Strukturierung der Gateelektrode bietet. Außerdem ist bei der Ätzung der Gateelektrode die Polysiliziumdicke in den aktiven Bereichen überall konstant, so daß die Überätzung minimiert werden kann und daraus eine größere Prozeßsicherheit resultiert.

In einer bevorzugten Weiterbildung des erfindungsgemäßen Verfahrens wird das Gateoxid durch thermische Oxidation hergestellt. Durch thermische Oxidation einer ebenen unstrukturierten Halbleiteroberfläche zu Beginn des Verfahrens wird ein dünnes Gateoxid mit hoher Qualität hergestellt, da die Halbleiteroberfläche eine geringe Defektdichte aufweist und zu Prozeßbeginn besonders eben ist.

Die über der Gateoxidschicht liegende Polysiliziumschicht wird vorzugsweise mit einer Dicke von 50 - 300 nm hergestellt. Generell wird versucht, die Dicke der Schicht so dünn wie möglich zu halten. Andererseits muß jedoch eine ausreichende Stärke der Feldplatten sichergestellt sein.

Auf die Polysiliziumschicht wird als Dielektrikum vorzugsweise CVD-Oxid abgeschieden. In einer bevorzugten Ausführungsform wird dieses durch eine Fototechnik und eine anisotrope Ätzung strukturiert. Auf diese Weise ist eine Strukturierung selektiv zum darunterliegenden Polysilizium möglich, und das Polysilizium kann in den aktiven Bereichen freigelegt werden.

Anschließend erzeugte Spacer werden bevorzugt aus Nitrid mit einer Breite von 50 - 100 nm hergestellt. Dieser Nitridspacer wirkt als Oxidationsbarriere und läßt sich im weiteren Verfahren besonders gut selektiv bearbeiten.

Zur Oxidation der Polysiliziumschicht wird bevorzugt ein LOCOS-Verfahren eingesetzt.

In einer bevorzugten Weiterbildung des erfindungsgemäßen Verfahrens wird anschließend eine leitfähige Schicht abgeschieden und zur Gateherstellung strukturiert. Diese leitfähige Schicht ist vozugsweise ein Silizid.

Nachfolgend wird die Erfindung anhand eines in der Zeichnung dargestellten Ausführungsbeispiels weiter erläutert. Im einzelnen zeigen die schematischen Darstellungen in den
- Fig. 1 bis 7: Querschnitte durch einen MOS-Transistor bei verschiedenen Verfahrensständen, und
- Fig. 8: eine Draufsicht auf einen MOS-Transistor.

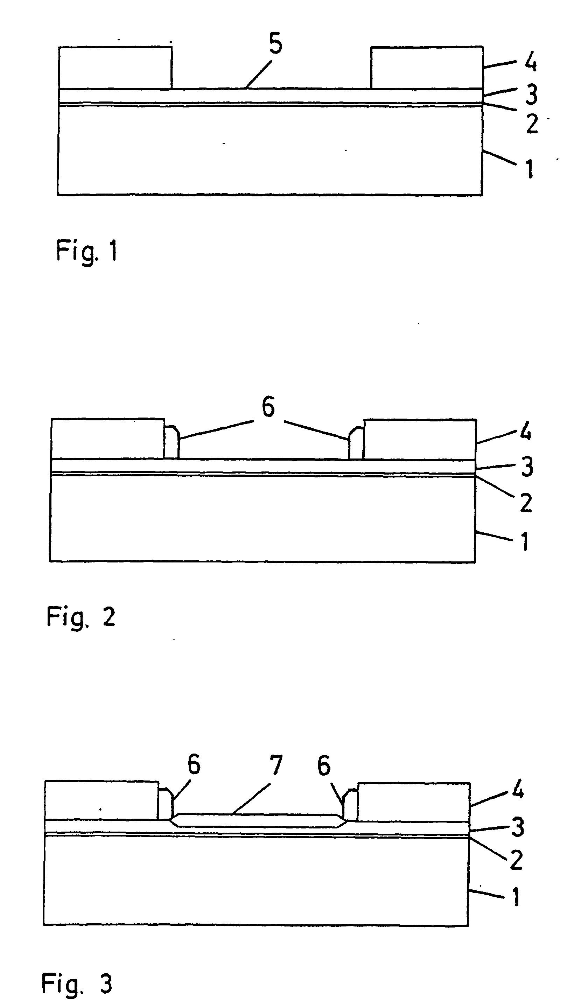

Auf einer ebenen, unstrukturierten Oberfläche eines Halbleitersubstrates 1 wird ein Gateoxid 2 durch thermische Oxidation oder durch ein entsprechendes anderes Verfahren hergestellt und mit einer Polysiliziumschicht 3 von etwa 50 bis 300 nm Dicke abgedeckt. Darauf wird ein CVD-Oxid 4 oder ein anderes Dielektrikum abgeschieden, das zur Bildung der Feldoxidbereiche vorgesehen ist. Mit einer Fototechnik und einer anisotropen Ätzung wird das CVD-Oxid 4 selektiv zur darunterliegenden Polysiliziumschicht 3 strukturiert, so daß ein aktiver Bereich 5 mit dem in diesem Bereich freiliegendem Polysilizium hergestellt wird. Dieser Verfahrensstand ist in Fig. 1 dargestellt, der einen Querschnitt durch einen MOS-Transistor während des Herstellungsverfahrens zeigt.

Im nächsten Schritt, der in Fig. 2 dargestellt ist, wird zur Erzeugung von Mikrogräben, auch Mikrotrenche genannt, an der senkrechten Feldoxidkante ein Spacer 6 erzeugt. Die senkrechte Kante am Feldoxid erhält man durch die anisotrope Ätzung des CVD-Oxids 4. Der Spacer 6 besteht aus Nitrid und ist etwa 50 - 100 nm breit und wirkt in den folgenden Schritten als Oxidationsbarriere. In Fig. 3 ist dargestellt, wie die im aktiven Bereich 5 freiliegende Polysiliziumschicht 3 teilweise aufoxidiert wird. Die entstandene Oxidschicht ist mit 7 bezeichnet und endet an der Grenze zum Spacer 6, so daß unterhalb des Spacers 6 weiterhin Polysilizium vorhanden ist. An dieser Stelle ist weiterhin wichtig, daß die Oxidation nicht durch die gesamte Polysiliziumschicht 3 erfolgt, sondern daß unterhalb der Oxidschicht 7 eine dünne Schicht Polysilizium verbleibt.

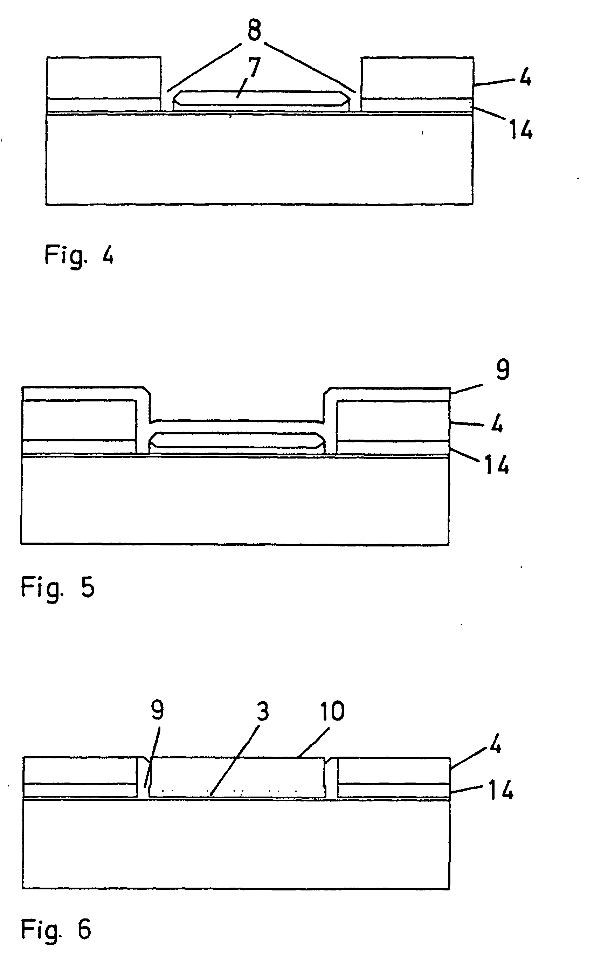

Im nächsten Schritt werden nun die Nitridspacer 6 isotrop entfernt und das darunterliegende Polysilizium der Polysiliziumschicht 3 wird anisotrop bis zum darunterliegenden Gateoxid 2 entfernt. Die Ätzung erfolgt selektiv zu Oxid, so daß die Oxidschicht 7 im aktiven Bereich als Maske wirkt und lediglich Isolationstrenche 8 im Bereich der vorherigen Spacer 6 entstehen. Dieser Verfahrensstand ist in Fig. 4 dargestellt.

Fig. 5 zeigt, wie im nächsten Schritt mit einer konformen Abscheidung von Oxid 9 die Isolationstrenche 8 aufgefüllt werden und die gesamte Struktur mit einer Oxidschicht 9 abgedeckt wird. Im nächsten Schritt wird eine Spacerätzung durchgeführt, bei der im aktiven Bereich sowohl die Oxidschicht 9 als auch die darunterliegende Oxidschicht 7 entfernt wird. In den Feldoxidbereichen wird in der gleichen Stärke wie im aktiven Bereich 5 die obenliegende Oxidschicht 9 und eine Schicht des darunterliegenden CVD-Oxids wieder entfernt. Der aktive Bereich wird durch selektive Abscheidung von Silizium 10 bis zum Niveau der Feldoxidbereiche erhöht. Dieser Verfahrensstand ist in Fig. 6 dargestellt.

Die erste Polysiliziumschicht 3 dient gleichzeitig zur Ausbildung der links und rechts gelegenen Feldplatten 14 und zum frühzeitigen Abdecken des darunterliegenden Gateoxids 2 und bildet einen Teilbereich des Gatepolysiliziums. Die elektrische Isolation zwischen den Feldplatten und dem Gatepolysilizium der selben Polysiliziumschicht 3 wird durch Mikrotrenche 8 hergestellt, so daß die Gatebereiche vollständig von den Bereichen des Feldplattenpolysiliziums getrennt sind.

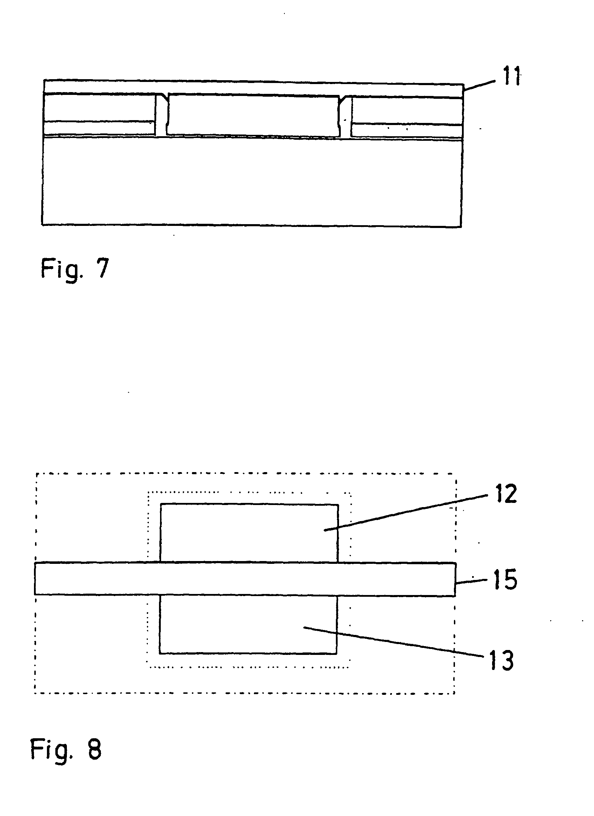

Die so hergestellte Halbleiterstruktur wird durch ganzflächige Abscheidung einer leitfähigen Schicht 11, die vorzugsweise aus einem Silizid besteht, weitergebildet. Aus dieser leitfähigen Schicht 11 wird die lokale Verbindung zwischen den einzelnen Polysiliziumbereichen hergestellt. Weiterhin wird die Strukturierung der Gatebereiche und der lokalen Verdrahtung der Gatebereiche mit einer zweiten Fototechnik in der leitfähigen Schicht 11 vorgenommen. Das Polysilizium 10 wird außerhalb der Gatebereiche in üblicher Weise geätzt. Diese Bereiche sind in Fig. 8 mit 12 und 13 bezeichnet. Bei dieser Ätzung ist nunmehr die Schicht überall gleich dick, so daß der Überätzschritt auf ein Minimum reduziert werden kann. Dies ergibt bei gleicher Ätztechnik ein höheres Prozeßfenster und erlaubt ein dünneres Gateoxid vorzusehen.

In Fig. 8 ist eine Draufsicht auf einen MOS-Transistor mit Source 12, Drain 13 und Gate 15 dargestellt. Nach der Gatestrukturierung erfolgt der Herstellungsprozeß in üblicher Weise mit Draindotierung und Metallisierung.

Die Dotierung der MOS-Transistoren kann in verschiedenen Stadien durch Implantation entweder vor der Herstellung des Gateoxids, nach dem Aufbringen der ersten Polysiliziumschicht und vor dem Aufbringen des Feldoxids oder nach der Gatestrukturierung erfolgen. Im Betrieb muß das Potential der Feldplatten annäherungsweise gleich dem Potential der darunter befindlichen Wannen sein. Dazu müssen die Feldplattenbereiche zumindest an einem Punkt elektrisch mit den zugehörigen Wannen kontaktiert werden. Dies kann bevorzugterweise durch verjustierte Wannenkontakte erfolgen, deren Kontaktflächen teilweise die Feldplatten und teilweise die zugehörigen Wannen kontaktieren.

## Patentansprüche

1. Verfahren zur Herstellung einer Halbleiterstruktur für einen MOS-Transistor, bei dem - in dieser Reitenfölge -
a) auf einem Substrat (1) ein Gateoxid (2) und darüber eine Polysiliziumschicht (3) erzeugt wird,
b) auf die Polysiliziumschicht (3) ein Dielektrikum abgeschieden wird,
c) das Dielektrikum zur Definition aktiver Bereiche (5) strukturiert wird,
d) an bei der Strukturierung entstandenen Rändern ein Spacer (6) hergestellt wird,
e) die Polysiliziumschicht (3) zwischen den Spacern teilweise aufoxidiert wird,
f) die Spacer (6) entfernt werden und das unter den Spacern liegende Polysilizium der Polysiliziumschicht (3) an isotrop entfernt wird,
g) ein Oxid (9) konform abgeschieden wird,
h) an dem abgeschiedenen Oxid (9) eine Spacerätzung durchgeführt wird, die im aktiven Bereich auch das im Schritt e) erzeugte Oxid entfernt, und
i) im aktiven Bereich Silizium (10) bis zur Höhe der angrenzenden Oxidstruktur abgeschieden wird.

2. Verfahren nach Anspruch 1,
**dadurch gekennzeichnet,**
**daß** das Gateoxid im Schritt a) durch thermische Oxidation erzeugt wird.

3. Verfahren nach einem der Ansprüche 1 oder 2,
**dadurch gekennzeichnet,**
**daß** im Schritt a) die Polysiliziumschicht (3) mit einer Dicke von 50 bis 300 nm Dicke abgeschieden wird.

4. Verfahren nach einem der Ansprüche 1 bis 3,
**dadurch gekennzeichnet,**
**daß** im Schritt b) als Dielektrikum ein CVD-Oxid abgeschieden wird.

5. Verfahren nach einem der Ansprüche 1 bis 4,
**dadurch gekennzeichnet,**
**daß** die Strukturierung des CVD-Oxids mit einer Fototechnik und
einer anisotropen Ätzung durchgeführt wird.

6. Verfahren nach einem der Ansprüche 1 bis 5,
**dadurch gekennzeichnet,**
**daß** im Schritt d) ein Spacer aus Nitrid mit einer Breite von 50 bis 100 nm hergestellt wird.

7. Verfahren nach einem der Ansprüche 1 bis 6,
**dadurch gekennzeichnet,**
**daß** die Oxidation der Polysiliziumschicht (3) im Schritt e) mit
einem LOCOS-Verfahren durchgeführt wird.

8. Verfahren nach einem der Ansprüche 1 bis 7,
**dadurch gekennzeichnet,**
**daß** anschließend eine leitfähige Schicht (11) abgeschieden und zur Gateherstellung strukturiert wird.

## Claims

1. Method for fabricating a semiconductor structure for a MOS transistor, in which - in this order -
a) a gate oxide (2) is produced on a substrate (1) and a polysilicon layer (3) is produced over the said gate oxide,
b) a dielectric is deposited onto the polysilicon layer (3),
c) the dielectric is patterned in order to define active regions (5),
d) a spacer (6) is fabricated on edges produced in the course of the patterning,
e) the polysilicon layer (3) is partly oxidized between the spacers,
f) the spacers (6) are removed and the polysilicon of the polysilicon layer (3) lying below the spacers is removed anisotropically,
g) an oxide (9) is deposited conformally,
h) a spacer etching is carried out on the deposited oxide (9) and, in the active region, also removes the oxide produced in step e), and,
i) in the active region, silicon (10) is deposited up to the level of the adjoining oxide structure.

2. Method according to Claim 1,
**characterized**
**in that** the gate oxide in step a) is produced by thermal oxidation.

3. Method according to either of Claims 1 and 2,
**characterized**
**in that**, in step a), the polysilicon layer (3) is deposited with a thickness of 50 - 300 nm.

4. Method according to one of Claims 1 to 3,
**characterized**
**in that**, in step b), a CVD oxide is deposited as dielectric.

5. Method according to one of Claims 1 to 4,
**characterized**
**in that** the patterning of the CVD oxide is carried out by means of a phototechnology and an anisotropic etching.

6. Method according to one of Claims 1 to 5,
**characterized**
**in that**, in step d), a spacer is fabricated from nitride with a width of 50 to 100 nm.

7. Method according to one of Claims 1 to 6,
**characterized**
**in that** the oxidation of the polysilicon layer (3) in step e) is carried out by means of a LOCOS method.

8. Method according to one of Claims 1 to 7,
**characterized**
**in that** a conductive layer (11) is subsequently deposited and patterned for the purpose of gate fabrication.

## Revendications

1. Procédé de fabrication d'une structure à semi-conducteur pour un transistor MOS, dans lequel successivement,
a) on produit sur un substrat (1) un oxyde (2) de grille et au-dessus une couche (3) en polysilicium,
b) on dépose sur la couche (3) en polysilicium un diélectrique,
c) on structure le diélectrique pour définir des zones (5) actives,
d) on produit sur les bords créés par la structuration un espaceur (6),
e) on oxyde en partie la couche (3) de polysilicium entre les espaceurs,
f) on élimine les espaceurs (6) et l'on élimine de manière anisotrope le polysilicium se trouvant en-dessous des espaceurs de la couche (3) en polysilicium,
g) on dépose un oxyde (9) de manière conforme,
h) on effectue sur l'oxyde (9) déposé une attaque d'espaceur, qui élimine dans la zone active également l'oxyde produit au stade e) et
i) on dépose dans la zone active du silicium (10) jusqu'au niveau de la structure d'oxyde adjacente.

2. Procédé suivant la revendication 1, **caractérisé en ce que** l'on produit l'oxyde de grille au stade a) par oxydation thermique.

3. Procédé suivant la revendication 1 ou 2, **caractérisé en ce que** l'on dépose au stade a) la couche (3) en polysilicium en une épaisseur de 50 à 30 nm.

4. Procédé suivant l'une des revendications 1 à 3, **caractérisé en ce que** l'on dépose au stade d) comme diélectrique un oxyde CVD.

5. Procédé suivant l'une des revendications 1 à 4, **caractérisé en ce que** l'on effectue la structuration de l'oxyde CVD par une technique photographique et par une attaque anisotrope.

6. Procédé suivant l'une des revendications 1 à 5, **caractérisé en ce que** l'on produit au stade d) un espaceur en nitrure d'une largeur de 50 à 100 nm.

7. Procédé suivant l'une des revendications 1 à 6, **caractérisé en ce que** l'on effectue l'oxydation de la couche (3) en polysilicium au stade e) par un procédé LOCOS.

8. Procédé suivant l'une des revendications 1 à 7, **caractérisé en ce que** l'on dépose ensuite une couche (11) conductrice et on la structure pour produire la grille.
